# EUROPÄISCHE PATENTSCHRIFT

(11) **EP 0 736 074 B1**
(45) Veröffentlichungstag und Bekanntmachung des Hinweises auf die Patenterteilung: **28.01.1998**
(21) Anmeldenummer: 95901449.9
(22) Anmeldetag: 28.11.1994
(51) Int. Cl.: C09D 4/06, C09D 163/00, C08F 2/46, B05D 3/06, G11B 3/70

(54) **STRAHLENHÄRTBARE SCHUTZLACKIERUNG, INSBESONDERE FÜR METALLISIERTE OBERFLÄCHEN**
RADIATION-CURABLE PROTECTIVE LACQUER, ESPECIALLY FOR METALLISED SURFACES
VERNIS PROTECTEUR DURCISSABLE PAR IRRADIATION, NOTAMMENT POUR SURFACES METALLISEES

(30) Priorität: 23.12.1993 DE 4344125
(43) Veröffentlichungstag der Anmeldung: 09.10.1996
(73) Patentinhaber: BASF Coatings Aktiengesellschaft, 48165 Münster (DE)
(72) Erfinder: SCHUNCK, Stephan, D-86161 Augsburg (DE)
(86) Internationale Anmeldenummer: EP9403940
(87) Internationale Veröffentlichungsnummer: WO9517476

(56) Entgegenhaltungen:
- EP-A- 0 393 407
- US-A- 4 428 807
- US-A- 4 657 779

## Beschreibung

Gegenstand der vorliegenden Erfindung ist ein strahlenhärtbares Beschichtungsmittel, enthaltend mindestens ein kationisch härtendes Epoxidharz, mindestens eine radikalisch härtende ethylenisch ungesättigte Verbindung und Photoinitiatoren.
Die Erfindung betrifft außerdem ein Verfahren zur Beschichtung metallisierter Oberflächen sowie die Verwendung der strahlenhärtbaren Beschichtungsmittel für die Lackierung von metallisierten Oberflächen, wie z.B. von Informationsträgern sowie insbesondere die Verwendung für die Lackierung der metallisierten Seite von Compact Discs.

Compact Discs werden aus hochreinem Polycarbonat durch Pressen unter Druck- und Hitzeeinwirkung hergestellt. Anschließend wird die Seite, die die Information trägt, mit einer reflektierenden Schicht aus Aluminium bedampft. Diese Aluminiumschicht ist nur etwa 7 bis 8.10⁻⁸m dick und muß vor Beschädigungen durch äußere Einflüsse und vor Korrosion geschützt werden, um ein fehlerfreies Abtasten der gespeicherten Information zu gewährleisten. Deshalb wird die metallisierte Schicht üblicherweise mit einer Klarlack-Schutzschicht versehen, die danach noch mit einem Label durch ein- oder mehrfarbiges Bedrucken mit einer konventionellen Druckfarbe versehen wird.

In vielen Fällen wird noch mit konventionellen, d.h. lösemittelhaltigen, Lacken für die Herstellung der Schutzschicht gearbeitet. Hohe Stückzahlen und die zunehmend strengeren gesetzlichen Auflagen für industrielle Lackieranlagen zur Begrenzung der Schadstoffemission führen aber dazu, daß verstärkt umweltfreundlichere, lösemittelfreie Lacke eingesetzt werden. Eine Alternative stellt die Beschichtung der metallisierten Seite von Compact Discs mit strahlenhärtbaren Lacken dar. Jedoch sind mit dieser Technologie einige spezifische Probleme strahlenhärtbarer Systeme verbunden. So beobachtet man bei strahlenhärtbaren Lacken eine Schrumpfung des Lackfilms beim Aushärten, da der Übergang vom flüssigen in den festen Zustand extrem schnell verläuft und mit der Polymerisation eine Volumenverminderung einhergeht. Auf chemisch nicht vorbehandelten Metalloberflächen kommt es dadurch zu gravierenden Haftungsproblemen. Übliche Haftvermittler können zur Lösung dieses Problems wegen der Gefahr einer frühzeitigen Korrosion der Aluminiumschicht nicht eingesetzt werden.
Probleme ergeben sich außerdem hinsichtlich der Bedruckbarkeit der Schutzlackschicht mit lösemittelhaltigen Druckfarben. Strahlenhärtbare Lacke ergeben nämlich im allgemeinen Beschichtungen mit extrem hoher Lösemittelfestigkeit. Dies führt dazu, daß die Haftung der Druckfarbe auf Schutzschichten aus strahlenhärtbaren Lacken nur unzureichend ist. Schließlich bereitet auch die nur unzureichende Kratzfestigkeit der gehärteten Beschichtungen Probleme.

Aus der US-PS 4,657,779 sind nun strahlenhärtbare Beschichtungsmittel bekannt, die nur einen so geringen Schrumpf zeigen, daß sie auch für die Beschichtung von deformierbaren Substraten, wie z.B. Polycarbonat-Compact-Discs, geeignet sind. Diese strahlenhärtbaren Lacke enthalten ein kationisch härtbares Polyepoxid, eine acrylatfunktionelle Komponente mit mindestens einer reaktiven Gruppe, eine acrylatfunktionelle Komponente zur Einstellung der Viskosität und eine Photoinitiatorkomponente. Diese aus der US-PS 4,657,779 bekannten strahlenhärtbaren Lacke weisen aber den Nachteil einer unzureichenden Kratzfestigkeit der gehärteten Lacke auf. Außerdem ist das Problem der Bedruckbarkeit der gehärteten Schutzschichten mit konventionellen Druckfarben nicht angesprochen.

Auch aus der EP-B-138 381 ist es bekannt, Compact-Discs mit strahlenhärtbaren Lacken zu beschichten. Als Beispiele für geeignete Lacke werden in der EP-B-138 381 Mischungen genannt, die ein radikalisch polymerisierbares Monomer und/oder Oligomer, eine kationisch polymerisierbare Verbindung, wie z.B. ein Epoxidharz und einen Photoinitiator enthalten. Auch der Einsatz dieser strahlenhärtbaren Lacke führt zu Beschichtungen mit nur einer unzureichenden Kratzfestigkeit.

Die Kombination von radikalisch und kationisch härtenden Systemen zur Verbesserung der technischen Eigenschaften der resultierenden Beschichtungen ist noch in weiteren Schriften, beispielsweise der EP-B-119 219 und der US-PS 4,428,807, beschrieben. In diesen Schriften ist jedoch kein Hinweis enthalten, diese strahlenhärtbaren Lacke für die Beschichtung metallisierter Oberflächen von Informationsträgern einzusetzen. Ferner weisen auch diese Systeme nur eine unzureichende Kratzfestigkeit der resultierenden Beschichtungen auf.

Der vorliegenden Erfindung liegt somit die Aufgabe zugrunde, strahlenhärtbare Beschichtungsmittel zur Verfügung zu stellen, die zu Überzügen mit einer guten Haftung auf metallisierten Oberflächen, hoher Kratzfestigkeit und guter Bedruckbarkeit mit konventionellen Druckfarben führen. Ferner sollten diese strahlenhärtbaren Beschichtungsmittel einen möglichst niedrigen Schrumpf beim Aushärten zeigen und zu klaren, transparenten Überzügen führen.

Überraschenderweise wird diese Aufgabe durch ein strahlenhärtbares Beschichtungsmittel, enthaltend mindestens ein kationisch härtendes Epoxidharz, mindestens eine radikalisch härtende ethylenisch ungesättigte Verbindung sowie eine Mischung aus mindestens einem Initiator für die Initiierung der kationischen Polymerisation und mindestens einem Initiator für die Initiierung der radikalischen Polymerisation, gelöst. Das Beschichtungsmittel ist dadurch gekennzeichnet, daß es
A) 20 bis 50 Gew.-% mindestens eines Präpolymers mit mindestens zwei ethylenisch ungesättigten Doppelbindungen,
B) 20 bis 60 Gew.-% mindestens eines kationisch härtenden Epoxidharzes,
C) 10 bis 30 Gew.-% mindestens eines Keton- und/oder Keton-/Formaldehydharzes,
D) 5 bis 40 Gew.-% mindestens eines Reaktivverdünners
   und
E) 5 bis 10 Gew.-% einer Mischung aus mindestens einem Initiator für die Initiierung der kationischen Polymerisation und mindestens einem Initiator für die Initiierung der radikalischen Polymerisation
enthält, wobei die Summe der Gewichtsanteile der Komponenten A bis E jeweils 100 Gew.-% beträgt.

Gegenstand der vorliegenden Erfindung ist außerdem ein Verfahren zum Beschichten metallisierter Oberflächen, bei dem die erfindungsgemäßen Beschichtungsmittel appliziert und mittels UV- oder Elektronenstrahlung ausgehärtet werden. Vorteilhafte Ausgestaltungen dieses Verfahrens ergeben sich aus den Unteransprüchen. Außerdem betrifft die Erfindung die Verwendung der strahlenhärtbaren Beschichtungsmittel für die Beschichtung von Informationsspeicherungsvorrichtungen. Gegenstand der Erfindung sind schließlich auch die mit dem Beschichtungsmittel beschichteten Informationspeicherungsvorrichtungen.

Es ist überraschend und war nicht vorhersehbar, daß durch die Kombination von radikalisch und kationisch härtenden Komponenten mit einer physikalisch trocknenden Komponente strahlenhärtbare Beschichtungsmittel erhalten werden, die zu Überzügen mit einer guten Haftung auf metallisierten Oberflächen, einer guten Kratzfestigkeit und einer guten Bedruckbarkeit mit konventionellen Druckfarben führen. Außerdem weisen die erfindungsgemäßen Beschichtungsmittel den Vorteil auf, daß sie nur einen geringen Schrumpf bei der Aushärtung zeigen und zu optisch transparenten Überzügen führen.

Im folgenden werden nun zunächst die einzelnen Komponenten der erfindungsgemäßen strahlenhärtbaren Beschichtungsmittel näher erläutert.
Als Komponente A sind Präpolymere geeignet, die mindestens zwei ethylenisch ungesättigte Doppelbindungen pro Molekül aufweisen. Als Grundgerüst können die unterschiedlichsten Harze eingesetzt werden. Bevorzugt leiten sich die Doppelbindungen von ethylenisch ungesättigten Carbonsäuren, bevorzugt von der Acryl- oder Methacrylsäure und besonders bevorzugt von der Acrylsäure ab. Daher sind als Komponente A beispielsweise Polyesteracrylate, Epoxidacrylate, Urethanacrylate oder acryloylgruppenhaltige Acrylatcopolymerisate geeignet. Die als Komponente A einsetzbaren Urethanacrylate sind bekannt und beispielsweise in der EP-B-167 199 und der EP-B-204 161 beschrieben. Sie können erhalten werden durch Umsetzung eines Di- oder Polyisocyanates mit einem Kettenverlängerungsmittel aus der Gruppe der Diole/Polyole und/oder Diamine/Polyamine und/oder Dithiole/Polythiole und/oder Alkanolamine und anschließende Umsetzung der restlichen freien Isocyanatgruppen mit mindestens einem Hydroxialkylacrylat oder Hydroxialkylester anderer ethylenisch ungesättigter Carbonsäuren.

Die Mengen an Kettenverlängerungsmittel, Di- bzw. Polyisocyanat und Hydroxialkylester einer ethylenisch ungesättigten Carbonsäure werden dabei so gewählt, daß
1.) das Äquivalentverhältnis der NCO-Gruppen zu den reaktiven Gruppen des Kettenverlängerungsmittels (Hydroxyl-, Amino- bzw. Mercaptylgruppen) zwischen 3 : 1 und 1 : 2, bevorzugt bei 2 : 1, liegt und
2.) die OH-Gruppen der Hydroxialkylester der ethylenisch ungesättigten Carbonsäuren in stöchiometrischer Menge in bezug auf die noch freien Isocyanatgruppen des Präpolymeren aus Isocyanat und Kettenverlängerungsmittel vorliegen.

Außerdem ist es möglich, die Polyurethanacrylate A herzustellen, indem zunächst ein Teil der Isocyanatgruppen eines Di- oder Polyisocyanates mit mindestens einem Hydroxialkylester einer ethylenisch ungesättigten Carbonsäure umgesetzt wird und die restlichen Isocyanatgruppen anschließend mit einem Kettenverlängerungsmittel umgesetzt werden. Auch in diesem Fall werden die Mengen an Kettenverlängerungsmittel, Isocyanat und Hydroxialkylester ungesättigter Carbonsäuren so gewählt, daß das Äquivalentverhältnis der NCO-Gruppen zu den reaktiven Gruppen des Kettenverlängerungsmittels zwischen 3 : 1 und 1 : 2, bevorzugt bei 2 : 1 liegt und das Äquivalentverhältnis der restlichen NCO-Gruppen zu den OH-Gruppen des Hydroxyalkylesters 1 : 1 beträgt.
Selbstverständlich sind auch sämtliche Zwischenformen dieser beiden Verfahren möglich. Beispielsweise kann ein Teil der Isocyanatgruppen eines Diisocyanates zunächst mit einem Diol umgesetzt werden, anschließend kann ein weiterer Teil der Isocyanatgruppen mit dem Hydroxialkylester einer ethylenisch ungesättigten Carbonsäure und im Anschluß hieran können die restlichen Isocyanatgruppen mit einem Diamin umgesetzt werden.

Diese verschiedenen Herstellverfahren der Polyurethanacrylate sind bekannt (vgl. beispielsweise EP-A-204 161) und bedürfen daher keiner genaueren Beschreibung.

Die als Komponente A geeigneten Epoxidacrylate sind ebenfalls bekannt und im Handel erhältlich. Sie können erhalten werden durch Anlagerung von Acrylsäure an Epoxidharze, beispielsweise an Epoxidharze auf Basis Bisphenol A oder andere handelsübliche Epoxidharze.

Weiterhin ist es möglich, als Komponente A ethylenisch ungesättigte, bevorzugt acryloxygruppenhaltige, Acrylatcopolymerisate einzusetzen. Diese ungesättigten Copolymerisate können erhalten werden durch Umsetzung eines Copolymerisates mit funktionellen Gruppen, wie beispielsweise Hydroxyl-, Carboxyl-, Amino-, Thiol-, Epoxid- oder Isocyanatgruppen, mit Verbindungen, die mindestens eine ethylenisch ungesättigte Doppelbindung sowie eine gegenüber den funktionellen Gruppen des Copolymerisats reaktionsfähige Gruppe aufweisen. Geeignete ethylenisch ungesättigte Acrylatcopolymerisate können beispielsweise erhalten werden durch Addition eines ethylenisch ungesättigten Isocyanates oder eines Anhydrids einer ethylenisch ungesättigten Carbonsäure oder einer ethylenisch ungesättigten Carbonsäure oder eines äquimolaren Additionsproduktes einer ethylenisch ungesättigten hydroxylgruppenhaltigen Verbindung und einer Diisocyanatverbindung an ein hydroxylgruppenhaltiges Acrylatharz.
Geeignete ethylenisch ungesättigte Acrylatcopolymerisate können beispielsweise auch erhalten werden durch Umsetzung eines carboxylgruppenhaltigen Acrylatharzes mit ethylenisch ungesättigten Verbindungen, die außerdem noch eine gegenüber Carboxylgruppen reaktionsfähige Gruppe aufweisen, wie z.B. Hydroxialkylester ethylenisch ungesättigter Carbonsäuren oder epoxidgruppenhaltige ethylenisch ungesättigte Verbindungen, wie z.B. Glycidyl(meth)acrylat.

Weiterhin können auch epoxidgruppenhaltige Acrylatharze mit ethylenisch ungesättigten Verbindungen umgesetzt werden, die eine gegenüber Epoxidgruppen reaktive Gruppe aufweisen, wie z.B. ethylenisch ungesättigte Carbonsäuren.

Als Komponente A werden jedoch bevorzugt acrylmodifizierte Polyester eingesetzt. Diese Polyester sind durch verschiedene Methoden herstellbar. Beispielsweise kann Acrylsäure oder eine andere ethylenisch ungesättigte Carbonsäure direkt als Säurekomponente beim Aufbau der Polyester eingesetzt werden. Daneben besteht die Möglichkeit, Hydroxialkylester der (Meth)Acrylsäure oder anderer ethylenisch ungesättigter Carbonsäuren als Alkoholkomponente direkt beim Aufbau der Polyester einzusetzen. Bevorzugt werden die acrylmodifizierten Polyester aber durch Acrylierung von Polyestern hergestellt. Beispielsweise können zunächst hydroxylgruppenhaltige Polyester aufgebaut werden, die dann mit Acryl- oder Methacrylsäure umgesetzt werden. Es können auch zunächst carboxylgruppenhaltige Polyester aufgebaut werden, die dann mit einem Hydroxialkylester der Acryl- oder Methacrylsäure umgesetzt werden.
Nicht umgesetzte (Meth)Acrylsäure kann durch Auswaschen, Destillieren oder bevorzugt durch Umsetzen mit einer äquivalenten Menge einer Mono- oder Diepoxidverbindung unter Verwendung geeigneter Katalysatoren, wie z.B. Triphenylphosphin, aus dem Reaktionsgemisch entfernt werden. Bezüglich weiterer Einzelheiten zur Herstellung der als Komponente A geeigneten Polyesteracrylate sei insbesondere auf die DE-OS 33 16 593 und die DE-OS 38 36 370 sowie auch auf die EP-A-54 105, die DE-AS 20 03 579 und die EP-B-2866 verwiesen.
Beispiele für als Komponente A geeignete Polyesteracrylate sind die unter folgenden Markennamen im Handel erhältlichen Produkte: verschiedene Laromer®-Typen der Firma BASF AG, wie z.B. Laromer® LR 8799, Laromer® LR 8828, Laromer® LR 8800, Laromer® PE 55F, Laromer® PE 46 und Laromer® PE 55W; Oligomer AS-X 95 und Oligomer AS-X6 der Firma Hans Rahn & Co., Zürich.
Selbstverständlich können als Komponente A auch Mischungen verschiedener Präpolymerer eingesetzt werden.
Die Komponente A wird in den Beschichtungsmitteln in einer Menge von 20 bis 50 Gew.-%, bezogen auf das Gesamtgewicht der Summe der Komponenten A bis E, eingesetzt.

Als weiteren erfindungswesentlichen Bestandteil enthalten die strahlenhärtbaren Beschichtungsmittel 20 bis 60 Gew.-%, bezogen auf das Gesamtgewicht der Summe der Komponenten A bis E, mindestens eines kationisch härtbaren Epoxidharzes (Komponente B).

Die als Komponente B geeigneten, kationisch härtbaren Epoxidharze sind bekannt. So können beispielsweise Epoxidharze auf Basis von Bisphenol A eingesetzt werden, die beispielsweise unter den Markennamen Epikote® der Firma Shell, Baklite® der Firma Union Carbide Corporation, Araldit® der Firma Ciba Geigy und DER® der Firma Dow Chemical vertrieben werden. Auch Epoxidharze vom Novolak-Typ sind einsetzbar.

Bevorzugt werden als Komponente B Harze aus cycloaliphatischen Epoxiden eingesetzt, wie z.B. 1,2-Epoxi-4-(epoxiethyl-) cyclohexan, 3,4-Epoxicyclohexylmethyl-3,4-epoxicyclohexancarboxylat, 2-(3,4-Epoxicyclohexyl-5,5-spiro-3,4-epoxi-)cyclohexan-metha-dioxan sowie Epoxicyclohexylalkyldicarboxilate, wie z.B. Bis-(3,4-epoxicyclohexylmethyl-)pimelat, Bis-(3,4-Epoxi-6-methylcyclohexylmethyl-)maleat, Bis-(3,4-epoxi-6-methylcyclohexylmethyl)-succinat, Bis-(3,4-epoxicyclohexylmethyl)-oxalat, Bis-(3,4-epoxi-6-methylcyclohexylmethyl)-sebacat und Bis-(3,4-epoxi-6-methylcyclohexylmethyl)-adipat.

Beispiele für geeignete cycloaliphatische Epoxide sind die unter den Markennamen Bakelite® ERL-4221, Bakelite® ERL-4299, Bakelite® ERL-4206 und Bakelite® ERL-4234 der Firma Union Carbide Corporation; Degacure® K 126 der Firma Degussa AG sowie Cyracure® UVR-6100 und Cyracure® UVR-6110 der Firma Union Carbide Corporation im Handel erhältlichen Produkte.

Als weiteren erfindungswesentlichen Bestandteil enthalten die strahlenhärtbaren Beschichtungsmittel als Komponente C 10 bis 30 Gew.-%, bezogen auf das Gesamtgewicht der Summe der Komponenten A bis E, mindestens eines Ketonharzes. Als Komponente C sind sowohl die reinen Ketonharze als auch Keton-/Formaldehydharze geeignet. Bevorzugt werden Ketonharze eingesetzt. Die als Komponente C geeigneten Harze weisen bevorzugt Erweichungspunkte zwischen 75 und 85°C auf.

Beispiele für geeignete Verbindungen sind die unter den folgenden Bezeichnungen im Handel erhältlichen Produkte: "Ketonharz A" der Firma BASF AG, ein Cyclohexanon-/Formaldehydharz; "Ketonharz N" der Firma BASF AG, ein Cyclohexanonharz; Laropal® K 80 und KLR 8804 der Firma BASF AG, Kondensationsprodukte aus Cyclohexanon.

Zur Einstellung der Viskosität der Beschichtungsmittel enthalten die Beschichtungsmittel außerdem 5 bis 40 Gew.-%, bezogen auf das Gesamtgewicht der Summe der Komponenten A bis E, mindestens eines Reaktivverdünners (Komponente D).
Als Komponente D geeignet sind Acrylate und Methacrylate, die radikalisch polymerisierbar sind und die eine oder mehrere ethylenisch ungesättigte Gruppen aufweisen, Vinyl- und Allyl-Monomere, Vinylether, N-Vinylmonomere, epoxidierte 1,2-Olefine und/oder gesättigte, niedrigviskose Verbindungen, die mindestens eine gegenüber den funktionellen Gruppen des Bindemittels (Komponente A oder B oder C) reaktive Gruppe aufweisen. Als Beispiele für geeignete Monomere seien Ethoxiethoxiethylacrylat, N-Vinylpyrrolidon, Phenoxiethylacrylat, Dimethylaminoethylacrylat, Hydroxiethylacrylat, Butoxiethylacrylat, Isobornylacrylat, Dimethylacrylamid, Dicyclopentylacrylat, 2-Acetoxiethylmethacrylat, Diacetonacrylamid, Butylacrylat, Glycidylacrylat, Glycidylmethacrylat, Cyclohexylacrylat, Phenylacrylat und Tertiärbutylacrylat genannt. Geeignet sind ferner Di-, Tri- und Polyacrylate, wie z.B. Butandioldiacrylat, Trimethylolpropandi- und -triacrylat, Pentaerythritdi- und -triacrylat, Glycerindi- und triacrylat, 1,6-Hexandioldiacrylat, Tetraethylenglykoldiacrylat, Diethylenglykoldiacrylat, Diethylenglykoldimethacrylat, Ethylenglykoldiacrylat, Neopentylglykoldiacrylat, Trimethylolethantriacrylat sowie Triacrylat-Oligomere, z.B. mit Acrylsäure verestertes propoxiliertes Glycerin (34,5 Mol-% Acrylsäure, 17,5 Mol-% Glycerin und 48,0 Mol-% Propandiol) mit im statistischen Mittel 3 Doppelbindungen pro Molekül, einem Doppelbindungsäquivalentgewicht von 160 und einem zahlenmittleren Molekulargewicht von 480, das im Handel unter der Bezeichnung "OTA 480" der Firma UCB Chemie GmbH, Drogenbos, Belgien, erhältlich ist sowie z.B. ein alkoxilierter tetrafunktioneller Acrylsäureester mit einem Doppelbindungsäquivalentgewicht von 145, der unter der Bezeichnung "MONIGOMER PPTTA" der Firma Hans Rahn & Co., Zürich im Handel erhältlich ist.

Geeignet sind ferner die in der EP-A-250 631 beschriebenen, langkettigen linearen Diacrylate mit einem zahlenmittleren Molekulargewicht von 400 bis 4000, bevorzugt 600 bis 2500. Beispielsweise können die beiden Acrylatgruppen durch eine Polyoxibutylenstruktur getrennt sein. Einsetzbar sind außerdem 1,12-Dodecyldiacrylat und das Umsetzungsprodukt von 2 Molen Acrylsäure mit einem Mol eines Dimerfettalkohols, der im allgemeinen 36 C-Atome aufweist.

Weiterhin sind als Komponente D auch gesättigte, niedrigviskose Verbindungen geeignet, die mindestens eine gegenüber den funktionellen Gruppen des Bindemittels reaktive Gruppe aufweisen, z.B. Alkohole, Diole, Lactone oder andere cyclische Ester sowie geradkettige Diepoxide u.ä. Diese können auch in Kombination mit ungesättigten Monomeren und/oder Oligomeren als Komponente D eingesetzt werden.

Die erfindungsgemäßen strahlenhärtbaren Beschichtungsmittel enthalten außerdem als Komponente E 5 bis 10 Gew.-%, bezogen auf das Gesamtgewicht der Summe, der Komponenten A bis E, einer Mischung von Photoinitiatoren zur Katalysierung der radikalischen Polymerisation der Komponenten A und D sowie zur Katalysierung der kationischen Polymerisation.
Zur Initiierung der radikalischen Polymerisation geeignet sind beispielsweise Benzoin, Benzoinether, substituierte Benzoine, Alkylether von substituierten Benzoinen, wie z.B. α-Methylbenzoinalkylether oder α-Hydroximethylbenzoinalkylether; Benzile, Benzilketale, z.B. Benzildimethylketal, Benzilmethylethylketal, Benzilmethylbenzylketal; Initiatoren auf Keton-Basis, z.B. Acetophenon und seine Derivate, z.B. Diethoxiacetophenon, m-Chloroacetophenon, Benzophenon und seine Derivate, z.B. 4,4'-Dimethylaminobenzophenon, 4,4'-Diethylaminobenzophenon, Propiophenon, Hydroxicyclohexyl-phenyl-keton, 2-Hydroxi-2-methyl-1-phenyl-propan-1-on; Anthrachinon und seine Derivate sowie Thioxanthon und seine Derivate sowie auch Mischungen verschiedener Initiatoren.
Geeignete Photoinitiatoren für die kationische Polymerisation sind ausführlich in der US-PS 4,156,035 beschrieben, auf die hier ausdrücklich Bezug genommen wird. Entsprechend der US-PS 4,156,035 ist daher als Komponente E jedes Onium-Salz mit Elementen der 6. Hauptgruppe geeignet, das in der Lage ist, bei Bestrahlung eine Lewis-Säure zu bilden. Beispiele für derartige Verbindungen sind Triphenylsulfoniumfluorborat und Triphenylsulfoniumhexafluorantimonat sowie weitere Triacrylsulfoniumsalze. Weiterhin geeignet sind Aryldiazoniumsalze oder Diaryljodoniumsalze mit verschiedenen Anionen, wie z.B. Tetrafluorborat, Hexafluorphosphat oder Hexafluorarsenat. Geeignet sind ferner Metall-Komplexe, wie z.B. das Eisen-Cyclopentadien-Alkylbenzol-Kation mit dem Hexafluorphosphat-Anion.

Die erfindungsgemäßen Überzugsmassen können ggf. noch übliche Hilfs- und Zusatzstoffe in üblichen Mengen, bevorzugt 0,05 bis 10 Gew.-%, bezogen auf das Gesamtgewicht des Beschichtungsmittels enthalten. Beispiele für derartige Stoffe sind Verlaufsmittel und Weichmacher.

Die erfindungsgemäßen strahlenhärtbaren Beschichtungsmittel weisen bevorzugt eine sehr geringe Viskosität auf, um mit einem Spin-Coater applizierbar zu sein. Der Spin-Coater stellt nämlich die bevorzugte Applikationsvorrichtung dar, da mit Hilfe dieses Auftragsverfahrens problemlos Beschichtungen mit einer glatten Oberflächenstruktur in der gewünschten Schichtdicke von 5 bis 30 µm erhalten werden. Diese Applikationsmethode ist bekannt. Wegen Einzelheiten sei daher nur auf die Literatur verwiesen.

Die erfindungsgemäßen Beschichtungsmittel können selbstverständlich auch mittels anderer bekannter Applikationsmethoden aufgebracht werden, beispielsweise mittels Spritzen, Walzen, Fluten, Tauchen, Rakeln oder Streichen. Außerdem können die erfindungsgemäßen Beschichtungsmittel auch in den üblichen Verfahren zur Beschichtung von Compact-Discs, wie sie z.B. in der EP-B-138 381 und der EP-A 72 378 beschrieben sind, eingesetzt werden.
Die Beschichtungsmittel können mittels UV- oder Elektronenstrahlung, bevorzugt mittels UV-Strahlung, ausgehärtet werden.
Die zur Aushärtung der Beschichtungsmittel angewandte Strahlung variiert in Abhängigkeit von der Absorption des Photopolymerisationsinitiators. Üblicherweise liegt die Wellenlänge der Strahlung im Bereich von 200 bis 600 nm. Geeignete Strahlungsquellen sind beispielsweise Kohlelichtbögen, Quecksilberdampflampen, Wolframlampen, Argon- und Xenonglühentladungslampen, photographische Flutlichtlampen und Leuchtstoffröhren mit ultraviolett emittierenden Phosphoren sowie Eximer-, Argon-, Xenonfluorid- und Kryptonfluorid-Laser.
Die Belichtungszeit ist in der Regel abhängig von der Art des eingesetzten strahlungsempfindlichen Harzes sowie von weiteren Faktoren, wie der Dicke der aufgebrachten Polymerschicht und dem gewählten Photoinitiator, der Art der Strahlungsquelle und deren Abstand vom Film. Die jeweilige Bestrahlungsdauer kann leicht durch Routineversuche ermittelt werden. Um die Filme möglichst wirtschaftlich aushärten zu können, sollten aber möglichst kurze Aushärtungsgeschwindigkeiten realisierbar sein.

Die erfindungsgemäßen Beschichtungsmittel eignen sich insbesondere für die Beschichtung metallisierter Oberflächen, können aber auch auf anderen Untergründen aufgebracht werden. Bevorzugt werden sie zur Beschichtung der metallisierten Seite von Informationsspeicherungsvorrichtungen eingesetzt, also als Schutzlackierung für die Seite, die die Information trägt. Hauptanwendungsgebiet ist dabei die Beschichtung der metallisierten Seite von Compact Discs. Vorteilhaft ist bei diesem Einsatz für die Beschichtung von Informationsspeichervorrichtungen auch die gute Bedruckbarkeit der erhaltenen Schutzlackierungen mit konventionellen Druckfarben, da beispielsweise Compact Discs üblicherweise nach dem Beschichten mit dem Schutzlack ein- oder mehrfarbig bedruckt werden. Entscheidend für dieses Anwendungsgebiet ist u.a. auch die gute Haftung der Schutzlackschicht, bei gleichzeitig guter Kratzfestigkeit.

Im folgenden wird nun die Erfindung anhand von Ausführungsbeispielen näher erläutert. Alle Angaben über Prozente und Teile sind dabei Gewichtsangaben, falls nicht ausdrücklich etwas anderes festgestellt wird.

### Beispiel 1

Zur Herstellung eines strahlenhärtbaren Beschichtungsmittels 1 werden zunächst 10 Teile eines handelsüblichen Cyclohexanonkondensationsharzes (Handelsprodukt Laropal® K 80 der Firma BASF AG, Lieferform: Pastillen, Erweichungspunkt nach DIN 53 180, 75-85°C, Säurezahl nach DIN 53 402, max. 1 mg KOH/g, Jodfarbzahl nach DIN 6162 max. 2), 25 Teile eines handelsüblichen cycloaliphatischen Epoxidharzes mit einem Epoxidäquivalentgewicht von 130 - 140 (Handelsprodukt CYRACURE® UVR-6100 der Firma Union Carbide Corporation;
Brookfield-Viskosität bei 25°C 85 - 115 mPas, Siedepunkt258°C), 25 Teile eines handelsüblichen Polyesteracrylates (Handelsprodukt Laromer LR 8828 der BASF AG, Ludwigshafen), 17,5 Teile mit Acrylsäure verestertes, propoxiliertes Glycerin (34,5 Mol-% Acrylsäure, 17,5 Mol-% Glycerin und 48,0 Mol-% Propandiol) mit im statistischen Mittel 3 Doppelbindungen pro Molekül, einem Doppelbindungsäquivalentgewicht von 160 und einem zahlenmittleren Molekulargewicht von 480 (Handelsprodukt "OTA 480" der Firma UCB Chemie GmbH, Drogenbos, Belgien) und 17,5 Teile eines handelsüblichen, epoxidgruppenhaltigen Reaktivverdünners mit einem Epoxidäquivalentgewicht von 120-130 und einer Brookfield-Viskosität von 15 mPas bei 25°C (Handelsprodukt Cyracure® UVR 6200 der Firma Union Carbide Corporation) homogenisiert. Abschließend werden 2,5 Teile Diethoxiacetophenon und 2,5 Teile eines handelsüblichen kationischen Initiators (Handelsprodukt Degacure® KI85 B der Firma Degussa AG; chemische Bezeichnung: Bis [4-(diphenylsulfonio)-phenyl]-sulfid-bis-hexafluorphosphat) unter Rühren zugefügt und homogenisiert.

Das so erhaltene Beschichtungsmittel 1 wird mittels eines Spin-Coaters mit einer Trockenfilmschichtdicke von 10 µm auf Compact-Discs appliziert. Die Aushärtung der Beschichtung erfolgt mit Hilfe einer UV-Bestrahlungsanlage, ausgerüstet mit zwei Hg-Mitteldruckstrahlern von je 80 W/cm Lampenleistung. Die eingestrahlte Dosis beträgt hierbei 0,15 J/cm², gemessen mit dem Dosimeter UVICURE, System EIT der Firma Eltosch. Sofort anschließend wird die Haftung auf der Metalloberfläche und die Kratzfestigkeit durch die Fingernagel-Ritzprüfung untersucht. Die Prüfergebnisse sind in Tabelle 1 dargestellt.
Zur Prüfung der Bedruckbarkeit werden die beschichteten Compact-Discs direkt nach dem Aushärten der Schutzlackschicht zunächst mit einer handelsüblichen konventionellen Druckfarbe bedruckt. Die Druckfarben zeigten dabei eine sehr gute Haftung.

### Vergleichsbeispiel 1

60 Teile des obenbeschriebenen Polyesteracrylates und 35 Teile des in Beispiel 1 beschriebenen, mit Acrylsäure veresterten propoxilierten Glycerins (Handelsprodukt "OTA 480" der Firma UCB Chemie GmbH) werden unter Rühren homogenisiert. Anschließend werden durch Rühren 5 Teile Diethoxiacetophenon in der Mischung homogen verteilt.
Das so erhaltene Beschichtungsmittel 2 wird analog Beispiel 1 mit einer Trockenfilmschichtdicke von 10 µm auf Compact-Discs appliziert und analog zu Beispiel 1 gehärtet (eingestrahlte Dosis 0,15 J/cm²). Die Prüfung der Haftung, Kratzfestigkeit und Bedruckbarkeit erfolgt ebenfalls analog zu Beispiel 1. Die Ergebnisse sind in Tabelle 1 dargestellt.

### Vergleichsbeispiel 2

30 Teile des oben beschriebenen Polyesteracrylates, 30 Teile des in Beispiel 1 beschriebenen cycloaliphatischen Epoxidharzes (Handelsprodukt Cyracure® UVR 6100 der Firma Union Carbide Corporation), 17,5 Teile des in Beispiel 1 beschriebenen, mit Acrylsäure veresterten propoxilierten Glycerins (Handelsprodukt "OTA 480" der Firma UCB Chemie GmbH) und 17,5 Teile des im Beispiel 1 beschriebenen epoxidgruppenhaltigen Reaktivverdünners (Handelsprodukt Cyracure® UVR 6200 der Firma Union Carbide Corporation) werden homogenisiert. Anschließend werden unter Rühren 2,5 Teile Diethoxiacetophenon und 2,5 Teile des in Beispiel 1 beschriebenen kationischen Härters (Handelsprodukt Degacure® KI85 der Firma Degussa AG) zugefügt.
Das so erhaltene Beschichtungsmittel 3 wird analog Beispiel 1 mit einer Trockenfilmschichtdicke von 10 µm auf Compact-Discs appliziert und analog zu Beispiel 1 gehärtet (eingestrahlte Dosis 0,15 J/cm²). Die Prüfung der Haftung, Kratzfestigkeit und Bedruckbarkeit erfolgt ebenfalls analog zu Beispiel 1. Die Ergebnisse sind in Tabelle 1 dargestellt.

**Tabelle 1:**

| Prüfergebnisse | | | |
|---|---|---|---|
| Beispiel 1 | | Vergleichsbeispiel 1 | Vergleichsbeispiel 2 |
| Schichtdicke µm | 10 | 10 | 10 |
| Fingernagel-Probe¹⁾ | i.O. | i.O. | n.i.O. |
| Bedruckbarkeit²⁾ | i.O. | - | i.O. |
| Haftung auf Metall | i.O. | n.i.O. | i.O. |

| | | | |
|---|---|---|---|
| 1) Es wird untersucht, ob sich die gehärtete Beschichtung durch Ritzen mit dem Fingernagel entfernen läßt. | | | |
| 2) Die gehärtete Beschichtung wird - wie in Beispiel 1 beschrieben - mit konventionellen Druckfarben bedruckt. Anschließend wird die Haftung der Druckfarbe auf der Schutzlackschicht beurteilt. | | | |

## Patentansprüche

1. Strahlenhärtbares Beschichtungsmittel, enthaltend mindestens ein kationisch härtendes Epoxidharz, mindestens eine radikalisch härtende ethylenisch ungesättigte Verbindung sowie eine Mischung aus mindestens einem Initiator für die Initiierung der kationischen Polymerisation und mindestens einem Initiator für die Initiierung der radikalischen Polymerisation, dadurch gekennzeichnet, daß das Beschichtungsmittel
A) 20 bis 50 Gew.-% mindestens eines Präpolymers mit mindestens zwei ethylenisch ungesättigten Doppelbindungen,
B) 20 bis 60 Gew.-% mindestens eines kationisch härtenden Epoxidharzes,
C) 10 bis 30 Gew.-% mindestens eines Keton- und/oder Keton/Formaldehydharzes,
D) 5 bis 40 Gew.-% mindestens eines Reaktivverdünners
und
E) 5 bis 10 Gew.-% einer Mischung aus mindestens einem Initiator für die Initiierung der kationischen Poymerisation und mindestens einem Initiator für die Initiierung der radikalischen Polymerisation
enthält, wobei die Summe der Gewichtsanteile der Komponenten A bis E jeweils 100 Gew.-% beträgt.

2. Strahlenhärtbares Beschichtungsmittel nach Anspruch 1, dadurch gekennzeichnet, daß es als Komponente A Urethanacrylate und/oder Epoxiacrylate und/oder Polyesteracrylate und/oder acryloylgruppenhaltige Acrylcopolymerisate enthält.

3. Strahlenhärtbares Beschichtungsmittel nach Anspruch 1 oder 2, dadurch gekennzeichnet, daß es als Komponente B cycloaliphatische Epoxidharze enthält.

4. Strahlenhärtbares Beschichtungsmittel nach einem der Ansprüche 1 bis 3, dadurch gekennzeichnet, daß das als Komponente C eingesetzte Keton- oder Keton-/Formaldehydharz einen Erweichungspunkt zwischen 75 und 85°C aufweist.

5. Verfahren zum Beschichten metallisierter Oberflächen, bei dem ein strahlenhärtbares Beschichtungsmittel aufgebracht und mittels UV- oder Elektronenstrahlung gehärtet wird, dadurch gekennzeichnet, daß ein Beschichtungsmittel nach einem der Ansprüche 1 bis 4 aufgebracht wird.

6. Verfahren nach Anspruch 5, dadurch gekennzeichnet, daß die metallisierte Oberfläche einer Informationsspeicherungsvorrichtung, die die Information trägt, beschichtet wird.

7. Verfahren nach Anspruch 6, dadurch gekennzeichnet, daß die metallisierte Oberfläche einer Compact Disc beschichtet wird.

8. Verfahren nach einem der Ansprüche 5 bis 7, dadurch gekennzeichnet, daß das ausgehärtete Beschichtungsmittel mit einer konventionellen Druckfarbe bedruckt wird.

9. Informationsspeicherungsvorrichtung, dadurch gekennzeichnet, daß sie mit einem Beschichtungsmittel nach einem der Ansprüche 1 bis 4 beschichtet ist.

10. Verwendung der strahlenhärtbaren Beschichtungsmittel nach einem der Ansprüche 1 bis 4 für die Beschichtung von Informationsspeicherungsvorrichtungen.

## Claims

1. Radiation-curable coating composition comprising at least one cationically curing epoxy resin, at least one free-radically curing, ethylenically unsaturated compound, and a mixture of at least one cationic polymerization initiator and at least one free-radical polymerization initiator, characterized in that the coating composition comprises
(A) from 20 to 50% by weight of at least one prepolymer containing at least two ethylenically unsaturated double bonds,
(B) from 20 to 60% by weight of at least one cationically curing epoxy resin,
(C) from 10 to 30% by weight of at least one ketonic and/or ketone-formaldehyde resin,
(D) from 5 to 40% by weight of at least one reactive diluent,
and
(E) from 5 to 10% by weight of a mixture of at least one cationic polymerization initiator and at least one free-radical polymerization initiator,
the sum of the proportions by weight of components A to E being in each case 100% by weight.

2. Radiation-curable coating composition according to Claim 1, characterized in that it contains as component A urethane acrylates and/or epoxy acrylates and/or polyester acrylates and/or acrylic copolymers which contain acryloyl groups.

3. Radiation-curable coating composition according to Claim 1 or 2, characterized in that it contains as component B cycloaliphatic epoxy resins.

4. Radiation-curable coating composition according to one of Claims 1 to 3, characterized in that the ketonic or ketone-formaldehyde resin employed as component C has a softening point of between 75 and 85°C.

5. Method of coating metallized surfaces, in which a radiation-curable coating composition is applied and is cured by means of UV radiation or electron beams, characterized in that a coating composition according to one of Claims 1 to 4 is applied.

6. Method according to Claim 5, characterized in that the metallized data-carrying surface of a data-storage device is coated.

7. Method according to Claim 6, characterized in that the metallized surface of a compact disc is coated.

8. Method according to one of Claims 5 to 7, characterized in that the cured coating composition is printed with a conventional printing ink.

9. Data-storage device, characterized in that it is coated with a coating composition according to one of Claims 1 to 4.

10. Use of the radiation-curable coating compositions according to one of Claims 1 to 4 for the coating of data-storage devices.

## Revendications

1. Agent d'enduction durcissable par irradiation contenant au moins une résine époxy durcissable par l'action de cations, au moins un composé à insaturation éthylénique durcissable par l'action de radicaux ainsi qu'un mélange d'au moins un amorceur pour amorcer la polymérisation cationique et d'au moins un amorceur pour amorcer la polymérisation radicalaire, caractérisé en ce que l'agent d'enduction contient :
A) 20 à 50% en poids d'au moins un prépolymère ayant au moins deux liaisons doubles à insaturation éthylénique,
B) 20 à 60% en poids d'au moins une résine époxy durcissable par l'action de cations,
C) 10 à 30% en poids d'au moins une résine de cétone et/ou de cétone/formaldéhyde,
D) 5 à 40% en poids d'au moins un diluant réactif, et
E) 5 à 10% en poids d'un mélange d'au moins un amorceur pour amorcer la polymérisation cationique et d'au moins un amorceur pour amorcer la polymérisation radicalaire,
la somme des fractions pondérales des composants A à E atteignant à chaque fois 100% en poids.

2. Agent d'enduction durcissable par irradiation selon la revendication 1, caractérisé en ce qu'il contient comme composant A des acrylates d'uréthannes et/ou des acrylates d'époxydes et/ou des acrylates de polyesters et/ou des copolymérisats acryliques contenant des groupes acryloyle.

3. Agent d'enduction durcissable par irradiation selon la revendication 1 ou 2, caractérisé en ce qu'il contient comme composant B des résines époxy cycloaliphatiques.

4. Agent d'enduction durcissable par irradiation selon l'une quelconque des revendications 1 à 3, caractérisé en ce que la résine de cétone ou de cétone/formaldéhyde utilisée comme composant C présente un point de ramollissement entre 75 et 85°C.

5. Procédé de revêtement de surfaces métallisées, dans lequel un agent d'enduction durcissable par irradiation est appliqué et durci au moyen d'un rayonnement U.V. ou d'un rayonnement électronique, caractérisé en ce qu'on applique un agent d'enduction selon l'une quelconque des revendications 1 à 4.

6. Procédé selon la revendication 5, caractérisé en ce qu'on revêt la surface métallisée d'un dispositif de mémorisation d'informations, qui porte les informations.

7. Procédé selon la revendication 6, caractérisé en ce qu'on revêt la surface métallisée d'un disque compact.

8. Procédé selon l'une quelconque des revendications 5 à 7, caractérisé en ce que l'agent d'enduction durci est imprimé avec une encre d'imprimerie classique.

9. Dispositif de mémorisation d'informations, caractérisé en ce qu'il est revêtu d'un agent d'enduction selon l'une quelconque des revendications 1 à 4.

10. Utilisation des agents d'enduction durcissables par irradiation selon l'une quelconque des revendications 1 à 4 pour le revêtement de dispositifs de mémorisation d'informations.
